# EUROPEAN PATENT APPLICATION

(11) **EP 4 696 923 A1**
(43) Date of publication of application: **18.02.2026**
(21) Application number: 24863306.7
(22) Date of filing: 14.08.2024
(51) Int. Cl.: F16M 11/04, G09F 9/302, G09F 9/33, H05K 5/02

(54) **DISPLAY APPARATUS**

(30) Priority: 08.09.2023 KR 20230119930
(71) Applicant: Samsung Electronics Co., Ltd., Suwon-si, Gyeonggi-do 16677 (KR)
(72) Inventor: LEE, Wookjin, Suwon-si Gyeonggi-do 16677 (KR); JI, Hyun, Suwon-si Gyeonggi-do 16677 (KR)
(74) Representative: Appleyard Lees IP LLP
(86) International application number: PCT/KR2024/096003
(87) International publication number: WO 2025/053727

(57) **Abstract**

A display apparatus including a display module, a cabinet to support the display module, the cabinet including an opening, an adjustment part arrangeable in the display module such that while the adjustment part is arranged in the display module, the adjustment part is movable with respect to the cabinet, a support member, moveable within the cabinet, and configured to support the adjustment part such that the adjustment part is moveable while supported on the support member, a rotation member coupleable to the support member and while coupled to the support member, the rotation member is configured to be rotatable such that the support member, the adjustment part, and the display module are moved based on a rotation of the rotation member. The rotation member is accessible through the opening of the cabinet to allow the rotation of the rotation member while the display module is supported on the cabinet.

## Description

### [Technical Field]

The present disclosure relates to a display apparatus.

### [Background Art]

In general, a display apparatus, which is a type of output device that converts obtained or stored electrical information into visual information and displays the converted visual information to a user, is used in various fields such as homes and businesses.

A display apparatus may include a plurality of displays to implement a large-sized screen. Each of the plurality of displays may include a plurality of display modules and a cabinet for supporting the plurality of display modules by continuously tiling the plurality of display modules up, down, left, and right. The plurality of displays may be provided to be capable of being continuously tiled up, down, left, and right, and may form one large-sized screen.

The plurality of displays may be stacked in an up-down direction by being supported on a floor, or may be hung by having upper ends thereof fixed to a separate structure. The plurality of displays may thermally expand as LEDs, substrates, and electrical components provided in the plurality of displays generate heat. While the plurality of displays is stacked in the up-down direction and operated, the plurality of displays may thermally expand to apply a force to the other stacked displays.

### [Disclosure]

### [Technical Problem]

The present disclosure is directed to providing a display apparatus capable of being easily adjust a height of a display module.

The present disclosure is directed to providing a display apparatus capable of preventing damage due to thermal expansion.

Technical tasks to be achieved in the present disclosure are not limited to the technical tasks mentioned above, and other technical tasks not mentioned will be clearly understood by those skilled in the art from the description below.

### [Technical Solution]

An aspect of the present disclosure provides a display apparatus including a display module, a cabinet to support the display module, the cabinet including an opening, an adjustment part arrangeable in the display module such that while the adjustment part is arranged in the display module, the adjustment part is movable with respect to the cabinet, a support member moveable within the cabinet and configured to support the adjustment part such that the adjustment part is moveable while supported on the support member, a rotation member coupleable to the support member and while coupled to the support member, the rotation member is configured to be rotatable such that the support member, the adjustment part, and the display module are moved based on a rotation of the rotation member, wherein the rotation member is accessible through the opening of the cabinet to allow the rotation of the rotation member while the display module is supported on the cabinet.

An aspect of the present disclosure provides a display apparatus including a cabinet, a display module coupleable to the cabinet, and a plurality of height adjustment devices, configured to adjust a height of the display module, and including a first height adjustment device , on the left side of the cabinet and a second height adjustment device , on the right side of the cabinet, wherein each of the plurality of height adjustment devices includes a bracket fixed to the display module, a support member configured to support the bracket and be movable in an up-down direction, and a rotation member coupleable to the support member to move the support member in the up-down direction and while coupled to the support member, the rotation member is configured such that the support member, the bracket, and the display module are moved in the up-down direction based on a rotation of the rotation member, and an angle of the display module is adjustable based on a movement of each of the support member of the first height adjustment device and the support member of the second height adjustment device.

An aspect of the present disclosure provides a display apparatus including a cabinet, a display module coupleable to the cabinet, a plurality of coupling members in the cabinet, a plurality of magnets in the display module to couple the display module to the cabinet by magnetic attraction with the plurality of coupling members, a bracket coupleable to the display module, a first adjustment member in contact with the bracket to adjust a height of the display module while the display module is coupled to the cabinet, and a second adjustment member configured to rotate to move the first adjustment member in a straight line in order to adjust the height of the display module.

### [Description of Drawings]

FIG. 1 is a perspective view of a display apparatus according to an embodiment.
FIG. 2 is a perspective view of a display of the display apparatus according to an embodiment.
FIG. 3 is an exploded perspective view of the display of the display apparatus according to an embodiment.
FIG. 4 is an exploded perspective view of the display of the display apparatus according to an embodiment.
FIG. 5 is a perspective view of a fixing frame of the display apparatus according to an embodiment.
FIG. 6 is a perspective view of the fixing frame of the display apparatus according to an embodiment.
FIG. 7 is a cross-sectional view of a display module of the display apparatus according to an embodiment.
FIG. 8 is a perspective view of a cabinet of the display apparatus according to an embodiment.
FIG. 9 is a perspective view of the cabinet of the display apparatus according to an embodiment.
FIG. 10 is a perspective view of the cabinet of the display apparatus according to an embodiment.
FIG. 11 is a perspective view of the display apparatus according to an embodiment.
FIG. 12 is a cross-sectional view of the display apparatus according to an embodiment.
FIG. 13 is a perspective view of the display apparatus according to an embodiment.
FIG. 14 is a cross-sectional view of the display apparatus according to an embodiment.
FIG. 15 is a cross-sectional view of the display apparatus according to an embodiment.
FIG. 16 is a perspective view of the display apparatus according to an embodiment.
FIG. 17 is a cross-sectional view of the display apparatus according to an embodiment.
FIG. 18 is a cross-sectional view of the display apparatus according to an embodiment.

### [Mode of the Disclosure]

The embodiments described in the present disclosure and the configurations shown in the drawings are only examples of preferred embodiments of the present disclosure, and various modifications may be made at the time of filing of the present disclosure to replace the embodiments and drawings of the present specification.

Like reference numbers or signs in the various drawings of the present disclosure represent parts or components that perform substantially the same functions.

The terms in the present disclosure are used for the purpose of describing the embodiments and are not intended to restrict and/or to limit the present disclosure. For example, the singular expressions may include plural expressions, unless the context clearly dictates otherwise. Also, the terms "includes" and "has" are intended to indicate that there are features, numbers, steps, operations, components, parts, or combinations thereof described in the present disclosure, and do not exclude the presence or addition of one or more other features, numbers, steps, operations, components, parts, or combinations thereof.

In the present disclosure, each of phrases such as "A or B," "at least one of A and B," "at least one of A or B," "A, B or C," "at least one of A, B and C," and "at least one of A, B, or C" may include any one of the items listed together in the corresponding one of the phrases, or all possible combinations thereof.

The term "and/or" includes any combination of a plurality of related components or any one of a plurality of related components.

It will be understood that, although the terms "first," "second," etc., may be used in the present disclosure to describe various components, these components should not be limited by these terms, and the terms are only used to distinguish one component from another. For example, without departing from the scope of the present disclosure, a first component may be referred to as a second component, and similarly, the second component may also be referred to as a first component. The term "and/or" includes any combination of a plurality of related items or any one of a plurality of related items.

In the present disclosure, the meaning of 'identical' includes things that have similar properties or are similar within a certain range. Also, the 'identical' means 'substantially identical'. The 'substantially identical' should be understood as falling within the scope of 'identical' as a value that falls within the margin of error in manufacturing or a value that corresponds to a difference within a range that has no meaning with respect to a reference value.

In addition, terms such as "~unit," "~part," "~block," "~member," and "~module" may denote a unit for processing at least one function or operation. For example, the terms may refer to at least one hardware such as a field-programmable gate array (FPGA)/an application specific integrated circuit (ASIC), at least one software stored in a memory, or at least one process processed by a processor.

In this specification, the terms "front," "rear," "left," and "right" used in the following description are defined with reference to the drawings, and the shape and position of each component are not limited by these terms.

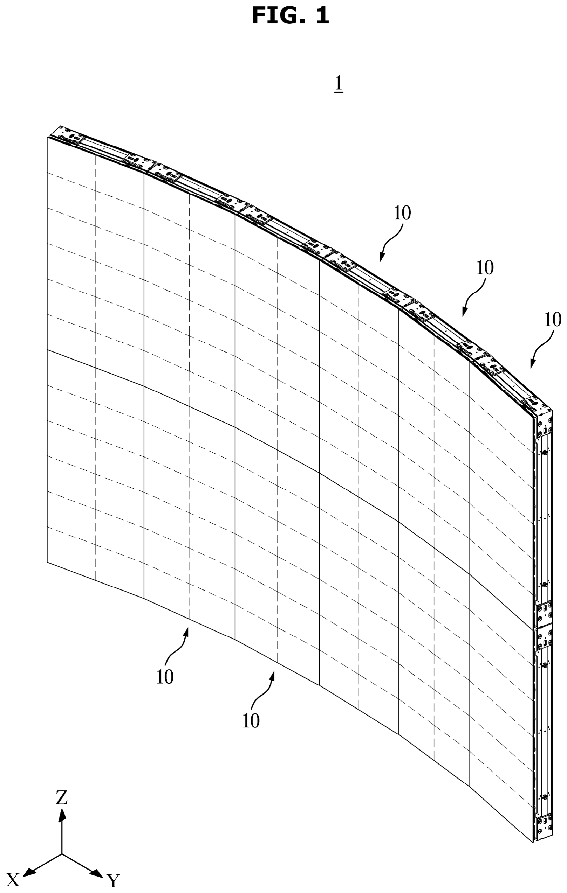

For example, directions of an X-axis, a Y-axis, and a Z-axis, which are perpendicular to each other, are shown in FIG. 1, and in this case, the X-axis direction may refer to a front-rear direction, the Y-axis direction may refer to a left-right direction, and the Z-axis direction may refer to an up-down direction.

Hereinafter, the embodiments of the present disclosure will be described in detail with reference to the accompanying drawings.

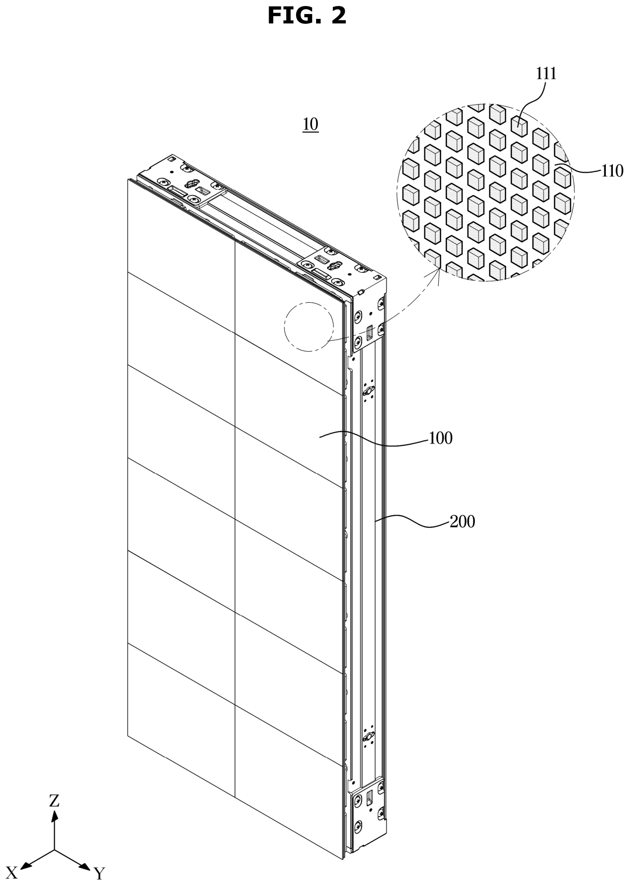

FIG. 1 is a perspective view of a display apparatus according to an embodiment. FIG. 2 is a perspective view of a display of the display apparatus according to an embodiment.

Referring to FIGS. 1 and 2, a display apparatus 1 is a device for displaying information, materials, data, etc., in the form of text, figures, graphs, images, etc., and a billboard, electronic signboard, screen, television, monitor, etc., may be implemented as the display apparatus 1. The display apparatus 1 may be installed on a floor, wall, or ceiling, or may be installed on an indoor or outdoor ground using a stand (not shown).

The display apparatus 1 may include a display 10. For example, the display apparatus 1 may be provided as a plurality of the displays 10. FIG. 1 illustrates that the number of the displays 10 included in the display apparatus 1 is twelve, but the number of the displays 10 is not limited thereto.

The display apparatus 1 may be implemented as a curved display apparatus using the plurality of displays 10. For example, each of the plurality of displays 10 may have a predetermined angle along a horizontal direction.

The plurality of displays may include a first display and a second display adjacent to the first display. The second display may include a display provided on an upper side, lower side, left side, and/or right side of the first display.

The display 10 may include a display module 100 provided to display a screen, and a cabinet 200 disposed at the rear of the display module 100 to support the display module 100.

In the display apparatus 1 according to an embodiment, twelve of the display modules 100 may be coupled to the one cabinet 200. For example, to the one cabinet 200, two of the display modules 100 may be coupled in the left-right direction Y, and six of the display modules 100 may be coupled in the up-down direction Z. The display modules 100 may be coupled to the cabinet 200 in the form of a 2*6 matrix. However, the number of the display modules 100 coupled to the cabinet 200 is not limited. Two or more of the display modules 100 may be coupled to the one cabinet 200.

The display apparatus 1 according to an embodiment may include the plurality of displays 10. For example, the display apparatus 1 may include twelve of the cabinets 200 and one hundred and forty-four of the display modules 100 coupled to the twelve cabinets 200. As such, the display apparatus 1 may be implemented as a large-sized curved screen as the plurality of cabinets 200 to which the plurality of display modules 100 is coupled is arranged adjacent to each other in the left-right direction Y and up-down direction Z. The number of the cabinets 200 arranged adjacent to each other in the left-right direction Y and up-down direction Z is not limited.

The display module 100 may include a substrate 110. A plurality of light-emitting diodes (LEDs) 111 may be mounted on a front surface of the substrate 110. The substrate 110 may be formed of a material such as glass, polyimide (PI), and FR4.

The display module 100 may include the plurality of LEDs 111 mounted on the substrate 110. Each of the plurality of LEDs 111 may include a red LED, a green LED, and a blue LED which are packaged as one pixel. The plurality of LEDs 111 may be mounted on the substrate 110 in a matrix form. The plurality of LEDs 111 is arranged to have a certain interval, and the interval between the plurality of LEDs 111 may be variously determined depending on the resolution and size of the display apparatus 1.

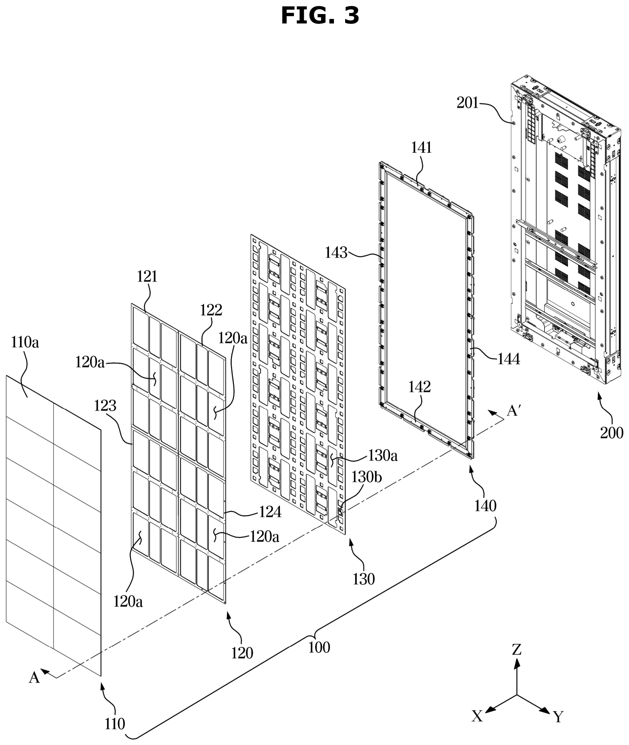

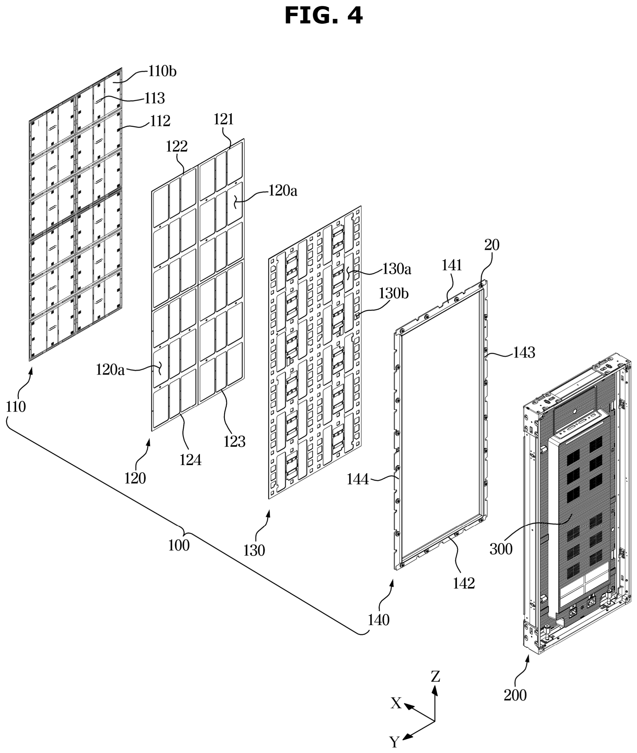

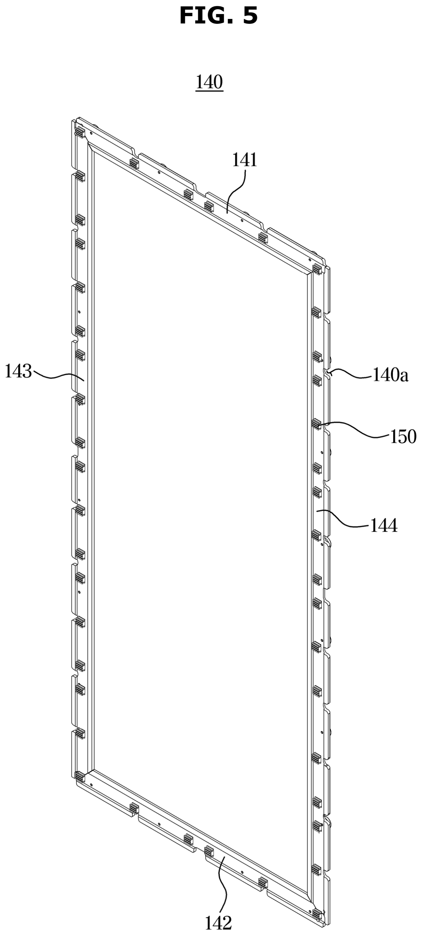

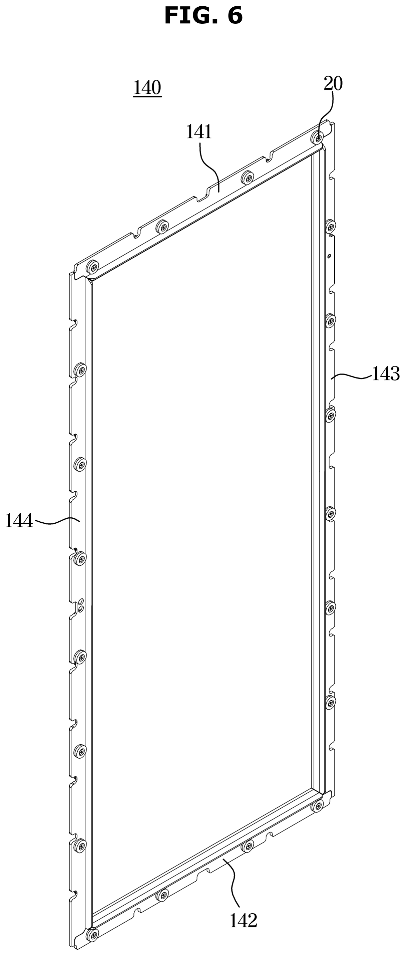

FIG. 3 is an exploded perspective view of the display of the display apparatus according to an embodiment. FIG. 4 is an exploded perspective view of the display of the display apparatus according to an embodiment. FIG. 5 is a perspective view of a fixing frame of the display apparatus according to an embodiment. FIG. 6 is a perspective view of the fixing frame of the display apparatus according to an embodiment.

FIG. 3 is a front perspective view of the display, and FIG. 4 is a rear perspective view of the display. FIG. 5 is a front perspective view of the fixing frame, and FIG. 6 is a rear perspective view of the fixing frame.

Referring to FIGS. 3 and 4, the display module 100 may be detachably coupled to the cabinet 200. The display module 100 may be separated from the cabinet 200 toward the front of the cabinet 200.

The display 10 may include a magnet 20. The magnet 20 may be provided as a plurality of the magnets 20. The plurality of magnets 20 may be provided on a rear surface of the display module 100. For example, the plurality of magnets 20 may be arranged along a fixing frame 140 of the display module 100.

The cabinet 200 may include a coupling member 201. The coupling member 201 may be provided as a plurality of the coupling members 201. The plurality of coupling members 201 may be provided on a front surface of the cabinet 200. For example, the plurality of coupling members 201 may be disposed along circumferences of a plurality of frames 210, 220, 230, and 240 of the cabinet 200.

The display module 100 may be coupled to the cabinet 200 by a magnetic force. For example, the display module 100 may be coupled to the cabinet 200 by magnetic attraction of the plurality of magnets 20 and the plurality of coupling members 201. For example, so that the display module 100 is coupled to the cabinet 200, positions of the plurality of coupling members 201 may correspond to positions of the plurality of magnets 20.

The coupling member 201 may have magnetic attraction in a relationship with the magnet 20. For example, the coupling member 201 may include a metal. Also, for example, the coupling member 201 may include the screw 201. However, the coupling member 201 is not limited to the above example. For example, the coupling member 201 may include the magnet 201.

The cabinet 200 may include the frames 210, 220, 230, and 240 provided to form outer edges of the cabinet 200. The display 10 may include a circuit case 300 coupled to the cabinet 200 to accommodate electrical components and/or printed circuit boards therein. The circuit case 300 may be disposed inside the frames 210, 220, 230, and 240. The circuit case 300 may include a connector corresponding to a connector included in each of the plurality of display modules 100.

The display module 100 may include the substrate 110. The substrate 110 may be disposed in front of reinforcing frames 120 and 130, the fixing frame 140, and the cabinet 200. The substrate 110 may include a front surface 110a and a rear surface 110b. The front surface 110a of the substrate 110 may face forward to emit light. The LEDs 111 may be electrically connected to the front surface 110a of the substrate 110. A mounting part 112 and a substrate connector 113 may be formed on the rear surface 110b of the substrate 110.

The substrate 110 may be provided as a plurality of the substrates 110. For example, the one display module 100 may include twelve of the substrates 110. For example, three of the substrates 110 may be provided on one of the first reinforcing frames 120. However, the number of the plurality of substrates 110 is not limited to the above example.

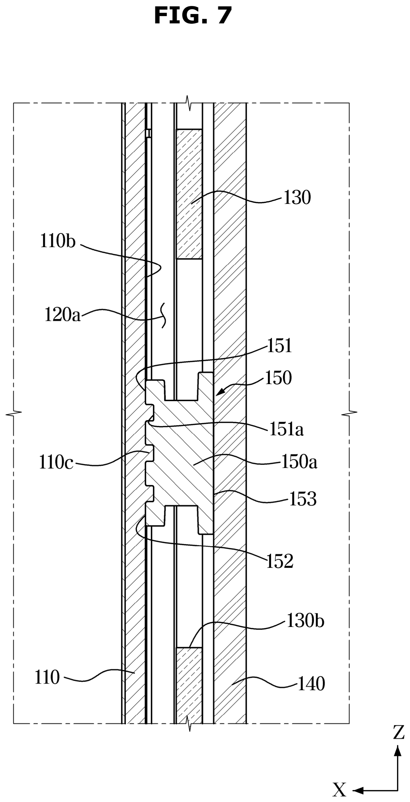

The mounting part 112 may be provided such that the substrate 110 is mounted on the cabinet 200. The mounting part 112 may be formed to correspond to a mounting member 150. The mounting part 112 and the mounting member 150 may be coupled to each other (see FIG. 7). The mounting part 112 may be provided as a plurality of the mounting parts 112. The plurality of mounting parts 112 may be formed on a circumference of the rear surface 110b of the substrate 110. However, the formation positions of the plurality of mounting parts 112 are not limited to the above example.

The substrate connector 113 may be electrically connected to a circuit connector provided in the circuit case 300. The substrate connector 113 may be formed to correspond to the circuit connector. The substrate connector 113 may be formed in a central portion of the rear surface 110b of the substrate 110. However, the formation position of the substrate connector 113 is not limited to the above example.

The display module 100 may include the reinforcing frames 120 and 130. The reinforcing frames 120 and 130 may be disposed between the substrate 110 and the cabinet 200 to reinforce the strength of the substrate 110. The reinforcing frames 120 and 130 may include reinforcing members, reinforcing parts, reinforcing portions, and/or reinforcing panels. The reinforcing frames 120 and 130 may include a plurality of the reinforcing frames 120 and 130. The plurality of reinforcing frames 120 and 130 may include the first reinforcing frame 120 and the second reinforcing frame 130.

The first reinforcing frame 120 may be disposed between the substrate 110 and the second reinforcing frame 130. The first reinforcing frame 120 may be disposed on the rear surface 110b of the substrate 110. The first reinforcing frame 120 may be adhered to the rear surface 110b of the substrate 110 through an adhesive member. For example, the front surface 110a of the first reinforcing frame 120 may be adhered to the substrate 110 through an adhesive member disposed on the circumference of the rear surface 110b of the substrate 110.

The first reinforcing frame 120 may be screw-coupled to the second reinforcing frame 130. For example, the first reinforcing frame 120 may be screw-coupled with the second reinforcing frame 130 by allowing the first reinforcing frame 120 forming a first hole 120a to be passed therethrough. The mounting member 150 and connectors may pass through the first hole 120a.

The first reinforcing frame 120 may be provided as a plurality of the first reinforcing frames 120. For example, the first reinforcing frame 120 may be provided as four of the first reinforcing frames 120. The plurality of first reinforcing frames 120 may include a first reinforcing frame 121 disposed in an upper right side, a first reinforcing frame 122 disposed in an upper left side, a first reinforcing frame 123 disposed in a lower right side, and a first reinforcing frame 124 disposed in a lower left side.

The plurality of substrates 110 may be adhered to one of the first reinforcing frames 120. For example, three of the substrates 110 may be adhered to the one first reinforcing frame 120. Because the plurality of first reinforcing frames 120 is separated from each other, even when only one of the twelve substrates 110 breaks down, only the first reinforcing frame 120 to which the substrate 110 that requires repair or replacement is adhered needs to be separated from the second reinforcing frame 130, and the other first reinforcing frames 120 do not need to be separated. Accordingly, repair of the display module 100 may be easy.

However, the number of the first reinforcing frames 120 is not limited to the above example. For example, the plurality of first reinforcing frames 120 may be formed as twelve to correspond to the number of substrates 110, formed as six, formed as two, or may be formed as one.

The second reinforcing frame 130 may be placed between the first reinforcing frame 120 and the fixing frame 140. The second reinforcing frame 130 may be screw-coupled with the first reinforcing frame 120 at the rear of the first reinforcing frame 120.

The second reinforcing frame 130 may include holes 130a and 130b. The holes 130a and 130b may be provided as a plurality of the holes 130a and 130b. The plurality of holes 130a and 130b may include the second hole 130a and the mounting hole 130b. The mounting member 150, which will be described later, may pass through the mounting hole 130b.

Referring to FIGS. 5 and 6, the display module 100 may include the fixing frame 140. An adjustment part 410 may be screw-coupled to the fixing frame 140. The adjustment part 410 may be fixed to the fixing frame 140 at the rear of the fixing frame 140. The fixing frame 140 may be disposed between the second reinforcing frame 130 and the cabinet 200. The fixing frame 140 may be screw-coupled with the second reinforcing frame 130 and may be coupled to the cabinet 200 by magnetic attraction. The fixing frame 140 may be provided as a plurality of the fixing frames 140.

The plurality of fixing frames 140 may include an upper fixing frame 141, a lower fixing frame 142, a left fixing frame 144, and a right fixing frame 143. The upper fixing frame 141 may be a first fixing frame, the lower fixing frame 142 may be a first fixing frame, the left fixing frame 144 may be a fourth fixing frame, and the right fixing frame 143 may be a third fixing frame. However, the names of the plurality of fixing frames are not limited to the above ordinal numbers.

The upper fixing frame 141 may be disposed at upper ends of the left fixing frame 144 and right fixing frame 143 and extend in the horizontal direction. The adjustment part 410 may be mounted, fixed, and coupled to the upper fixing frame 141.

The lower fixing frame 142 may be disposed at lower ends of the left fixing frame 144 and right fixing frame 143 and extend in the horizontal direction.

The left fixing frame 144 may be disposed at left ends of the upper fixing frame 141 and lower fixing frame 142 and extend in a vertical direction. The right fixing frame 143 may be disposed at right ends of the upper fixing frame 141 and lower fixing frame 142 and extend in the vertical direction.

The mounting member 150 may be disposed on a front surface of each of the plurality of fixing frames 140. The mounting member 150 may be provided such that the substrate 110 is mounted on the fixing frame 140. The mounting member 150 may be provided as a plurality of the mounting members 150. The plurality of mounting members 150 may be arranged along the plurality of fixing frames 140 (see FIG. 7).

The plurality of magnets 20 may be disposed on a rear surface of each of the plurality of fixing frames 140. The plurality of magnets 20 may be arranged along the plurality of fixing frames 140. The display module 100 may be coupled to the cabinet 200 by magnetic attraction. For example, the magnets 20 provided on the plurality of fixing frames 140 and the coupling members 201 provided in the cabinet 200 may have magnetic attraction so that the display module 100 is coupled to the cabinet 200.

A fixing groove 140a may be formed on each of the plurality of fixing frames 140. The fixing groove 140a may be recessed inward from a circumference of the fixing frame 140 to allow the first reinforcing frame 120 and the second reinforcing frame 130 to be screw-coupled. The fixing groove 140a may be provided as a plurality of the fixing grooves 140a.

The fixing frame 140 may include a mounting frame, a mounting panel, and a fixing panel.

FIG. 7 is a cross-sectional view of a display module of the display apparatus according to an embodiment. FIG. 7 is an enlarged cross-sectional view of the display module cut along A-A'.

Referring to FIG. 7, the substrate 110 may be mounted on the fixing frame 140 through the mounting member 150. The mounting part 112 may be formed on the rear surface 110b of the substrate 110. The mounting part 112 may protrude from the rear surface 110b of the substrate 110. The mounting part 112 may include a protrusion and/or a projection 110c. The mounting part 112 may be accommodated within the mounting member 150.

The mounting member 150 may be disposed between the substrate 110 and the fixing frame 140. The mounting member 150 may be disposed in the first hole 120a of the first reinforcing frame 120. The mounting member 150 may be disposed in the mounting hole 130b of the second reinforcing frame 130.

The mounting member 150 may be disposed on the front surface of the fixing frame 140. For example, the mounting member 150 may be screw-coupled to the fixing frame 140. Also, for example, a rear surface 153 of the mounting member 150 may be in contact with the fixing frame 140.

The mounting member 150 may include a mounting groove 151a recessed from a front surface 151 of a body 150a. The mounting member 150 may include a front surface 152 at an opposite from the front surface 151. The mounting groove 151a of the mounting member 150 and the mounting part 112 may correspond to each other. However, the shapes of the mounting part 112 and the mounting member 150 are not limited to the above example. For example, the mounting part 112 may include a mounting groove recessed from a rear surface 150b of the substrate, and the mounting member 150 may include a protrusion protruding from the front surface 151 of the mounting member 150 to correspond to the mounting groove of the mounting part 112.

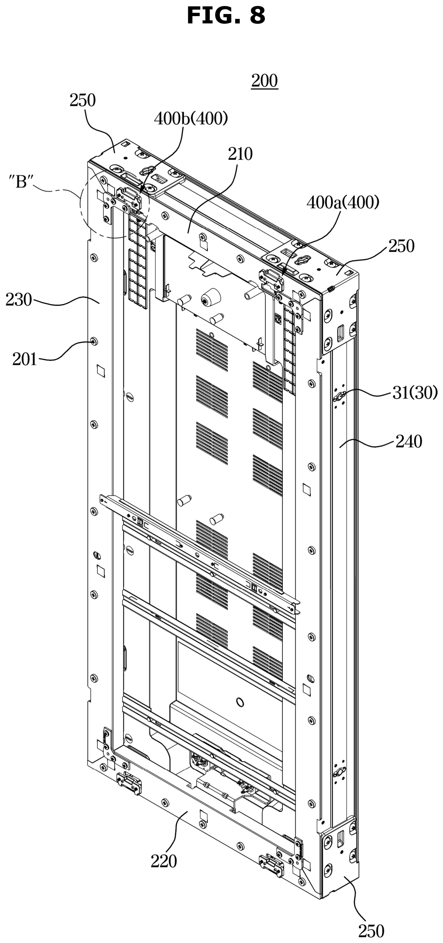

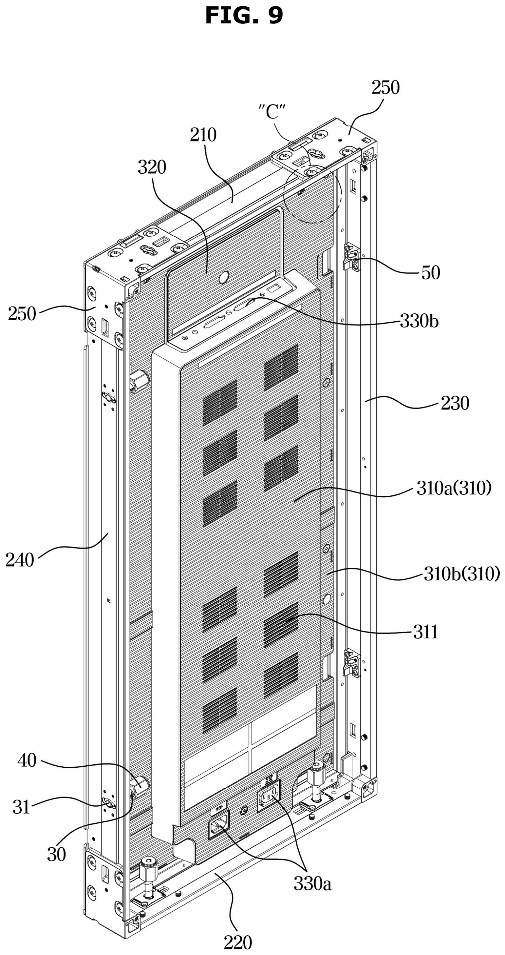

FIG. 8 is a perspective view of a cabinet of the display apparatus according to an embodiment. FIG. 9 is a perspective view of the cabinet of the display apparatus according to an embodiment. FIG. 8 is a front perspective view of the cabinet, and FIG. 9 is a rear perspective view of the cabinet.

Referring to FIGS. 8 and 9, the cabinet 200 may include the plurality of frames 210, 220, 230, and 240. The plurality of frames 210, 220, 230, and 240 may include the upper end frame 210, the lower end frame 220, the left frame 240, and the right frame 230. The upper end frame 210 may include a support frame. The upper end frame 210 may be a first frame, the lower end frame 220 may be a second frame, the right frame 230 may be a third frame, and the left frame 240 may be a fourth frame. However, the ordinal numbers of the plurality of frames are not limited to the above example.

The upper end frame 210 is disposed at upper ends of the left frame 240 and right frame 230 and extend in the horizontal direction. The adjustment part 410 may be inserted into and/or mounted on the upper end frame 210. The upper end frame 210 may be an upper frame.

The lower end frame 220 may be disposed at lower ends of the left frame 240 and right frame 230 and extend in the horizontal direction. The lower end frame may be a lower frame.

The left frame 240 may be disposed at left ends of the upper end frame 210 and lower end frame 220 and extend in the vertical direction. The right frame 230 may be disposed at right ends of the upper end frame 210 and lower end frame 220 and extend in the vertical direction. The left frame 240 and the right frame 230 may be side frames.

The plurality of frames may further include an edge frame 250. The edge frame 250 may be provided as a plurality of the edge frames 250. The plurality of edge frames 250 may be disposed at positions where the first frame, second frame, third frame, and fourth frame are in contact with each other. The plurality of edge frames 250 may cover ends of the first frame, second frame, third frame, and fourth frame.

For example, the plurality of edge frames 250 may include the edge frame 250 disposed at the position where the upper end frame 210 and the left frame 240 are in contact with each other, the edge frame 250 disposed at the position where the upper end frame 210 and the right frame 230 are in contact with each other, the edge frame 250 disposed at the position where the lower end frame 220 and the left frame 240 are in contact with each other, and the edge frame 250 disposed at the position where the lower end frame 220 and the right frame 230 are in contact with each other. The plurality of edge frames 250 may be coupled to the upper end frame 210, lower end frame 220, left frame 240, and/or right frame 230 at each position.

The plurality of coupling members 201 may be disposed on the cabinet 200. The plurality of coupling members 201 may be arranged along the upper end frame 210, lower end frame 220, left frame 240, and right frame 230. The display module 100 may be mounted on and/or coupled to the cabinet 200 through the plurality of coupling members 201 provided in the cabinet 200 and the plurality of magnets 20 provided in the display module 100.

The display 10 may include a mounting shaft 30 and a fixing nut 40. The mounting shaft 30 and the fixing nut 40 may connect, couple, fasten, and/or fix the plurality of displays 10 to each other. The mounting shaft 30 may penetrate the left frame 240, the right frame 230, and/or the lower end frame 220 to connect and/or fix the plurality of cabinets 200. For example, the mounting shaft 30 and the fixing nut 40 may be provided in the first cabinet 200 to be inserted into the adjacent second cabinet 200. The second cabinet 200 may include the cabinet 200 provided above, below, on the left and/or right side of the first cabinet 200.

The mounting shaft 30 provided in the first cabinet 200 may connect the first cabinet 200 and the second cabinet 200 as a fastening part 31 provided at one end of the mounting shaft 30 is inserted into a fastening part 50 formed on the left frame 240, the right frame 230, and/or the lower end frame 220 of the second cabinet 200. The fixing nut 40 may fix a movement of the mounting shaft 30 while the mounting shaft 30 connects the first cabinet 200 and the second cabinet 200.

The display 10 may include the circuit case 300. The circuit case 300 may form the rear of the display 10 and cover the rear of the display module 100. The circuit case 300 may include a first case part 310 and a second case part 320. The first case part 310 may cover a portion of the rear of the display module 100. A connector 330a may be formed below the first case part 310. The connector 330a formed below the first case part 310 may be provided to allow an electrical component disposed in the circuit case 300 to be connected to an external cable. The second case part 320 may cover a portion of the rear of the display module 100. The second case part 320 may be coupled to the first case part 310. A connector hole 330b may be formed on the second case part 320 to allow an electrical component disposed in the circuit case 300 to be connected to an external cable. The first case part 310 and the second case part 320 may be formed integrally.

The first case part 310 may include a first portion 310a and a second portion 310b. The first portion 310a and the second portion 310b may have a step difference. The first portion 310a may be disposed further rear than the second portion 310b. An exhaust hole 311 may be formed on the first portion 310a to release air heated due to heat generation from an electrical component. For example, an electrical component may be disposed between the display module 100 and the first portion 310a. The second portion 310b may be disposed closer to the display module 100 than the first portion 310a.

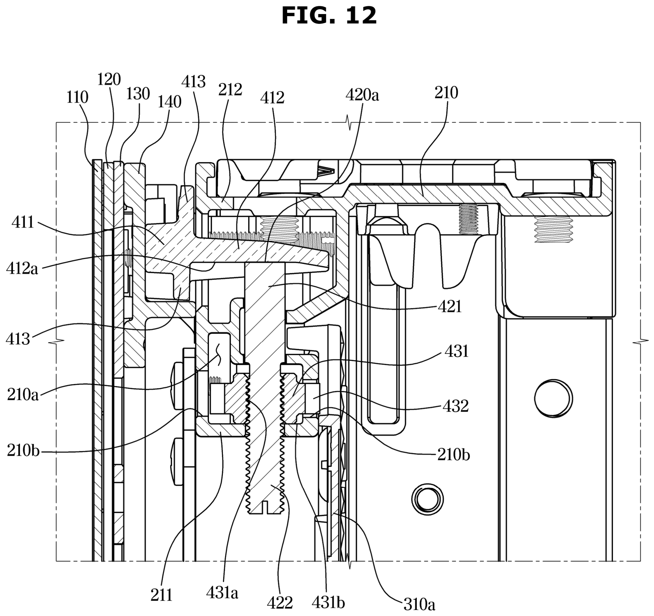

The display may include a height adjustment device 400. The height adjustment device 400 may include the adjustment part 410, a first adjustment member, and a second adjustment member (see FIG. 12). The height adjustment device 400 may be provided as a plurality of the height adjustment devices 400. The plurality of height adjustment devices 400 may include a first height adjustment device 400a and a second height adjustment device 400b. For example, the first height adjustment device 400a may be disposed on the left side of the cabinet 200, and the second height adjustment device 400b may be disposed on the right side of the cabinet 200. However, the present disclosure is not limited thereto, the first height adjustment device may be disposed on the right side of the cabinet 200, and the second height adjustment device may be disposed on the left side of the cabinet 200. Each of the first height adjustment device 400a and the second height adjustment device 400b may adjust a height of the display module 100, and thereby adjust an angle of the display module 100 with respect to the ground or horizontal.

Hereinafter, this will be described based on the second height adjustment device 400b. The description of the first height adjustment device 400a may be substantially the same as the description of the second height adjustment device 400b.

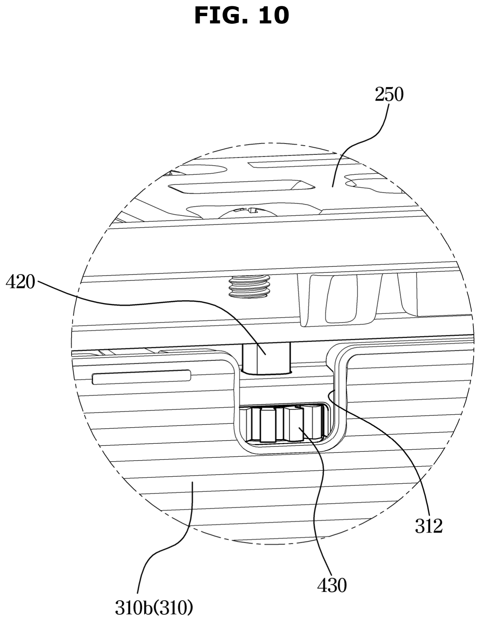

FIG. 10 is a perspective view of the cabinet of the display apparatus according to an embodiment. FIG. 10 is an enlarged view of area C of the cabinet illustrated in FIG. 9.

Referring to FIG. 10, an adjustment groove 312 may be formed on the second portion 310b of the first case part 310. The adjustment groove 312 may be recessed from one end of the second portion 310b. For example, the adjustment groove 312 may be recessed from an upper end of the second portion 310b. The adjustment groove 312 may be recessed from a circumference of the second portion 310b. For example, the adjustment groove 312 may be cut from the circumference of the second portion 310b. A rotation member 430 may be exposed through the adjustment groove 312 and an opening 210b formed on the upper end frame 210. The rotation member 430 may be accessible through the opening 210b. A user may adjust the height of the display module 100 by rotating the exposed rotation member 430. The user may easily adjust the height of the display module 100 from the rear of the display module 100 without separating the display module 100 from the cabinet 200. Accordingly, the man-hours for adjusting the height of the display module 100 may be reduced, and the time required for height adjustment may be reduced.

However, the rotation member 430 may not be disposed within the upper end frame 210, but may be disposed outside the upper end frame 210 and the cabinet 200.

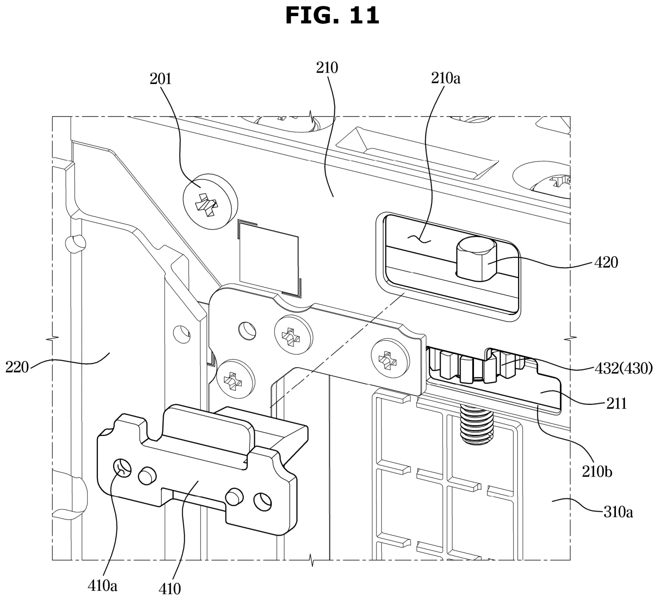

FIG. 11 is a perspective view of the display apparatus according to an embodiment. FIG. 12 is a cross-sectional view of the display apparatus according to an embodiment. FIG. 11 is an enlarged view of area B illustrated in FIG. 8.

Referring to FIGS. 11 and 12, the display 10 may include the adjustment part 410. The adjustment part 410 may be provided in the display module 100. The adjustment part 410 may be accommodated within the cabinet 200. For example, the adjustment part 410 may be disposed within the upper end frame 210. The adjustment part 410 may be provided in the display module 100. The adjustment part 410 may be fastened, coupled, and/or fixed to the fixing frame 140. For example, adjustment part 410 may be screw-coupled to fixing frame 140. The adjustment part 410 may be a component included in the display module 100.

The adjustment part 410 may be withdrawn and/or detachable from the cabinet 200. For example, the adjustment part 410 may be withdrawn from an accommodating portion 210a formed within the upper end frame 210.

The adjustment part 410 may include a body 411. The body 411 may be disposed between the display module 100 and the upper end frame 210. For example, the body 411 may be disposed between the fixing frame 140 and the upper end frame 210 along the front-rear direction.

A fastening hole 410a may be formed on the body 411 of the adjustment part 410, and a fastening member may be inserted into the fastening hole 410a to fasten the adjustment part 410 and the fixing frame 140.

The adjustment part 410 may include a contact portion 413. The contact portion 413 may extend from the body 411 in the up-down direction. The contact portion 413 may be in contact with the upper end frame 210 and the fixing frame 140. For example, the contact portion 413 may be in contact with a front surface of the upper end frame 210. Also, for example, the contact portion may be in contact with an extension portion protruding toward the rear of the fixing frame 140. The adjustment part 410 may be supported by the extension portion of the fixing frame 140. Because the contact portion 413 of the adjustment part 410 is in contact with and supported on the upper end frame 210 and the fixing frame 140, the adjustment part 410 may be moved in the up-down direction by the support member 420 without changing a position thereof, and accordingly, the display module 100 may be moved in the up-down direction.

The adjustment part 410 may include a support portion 412. The support portion 412 may extend rearward from the body 411 of the adjustment part. The support portion 412 may be in contact with an upper surface 420a of the support member 420, and may support the adjustment part 410 on the support member 420. The support portion 412 may be disposed between the upper end frame 210 and the support member 420 along the up-down direction.

The adjustment part 410 may include an adjustment portion, bracket, and/or latch.

The display 10 may include the support member 420. The support member 420 may extend in one direction to support the adjustment part 410. The support member 420 may be moved along one direction. For example, the support member 420 may extend in the up-down direction to be in contact with and support the adjustment part 410, and may be moved in the up-down direction to adjust a height of the adjustment part 410 and the height of the display module 100. The support member 420 may be disposed within the accommodating portion 210a of the upper end frame 210.

The support member 420 may include an extension portion 421. The extension portion 421 may extend along the up-down direction. An upper surface 420a of the extension portion 421 of the support member 420 may be in contact with a lower surface 412a of the support portion 412 of the adjustment part 410.

The support member 420 may include a coupling portion 422. The rotation member 430 may be coupled to the coupling portion 422. Screw threads or grooves may be formed on the coupling portion 422 so that the rotation member 430 may be rotatably coupled thereto. The coupling portion 422 may be formed on one side of the extension portion 421. For example, the coupling portion 422 may be formed below the extension portion 421. However, the coupling portion 422 may be formed above the extension portion 421 so that the coupling portion 422 may be in contact with the adjustment part 410. The coupling portion 422 may be inserted by penetrating a rotation body 431 of the rotation member 430.

The display may include the rotation member 430. The rotation member may be accommodated within cabinet 200. For example, the rotation member 430 may be disposed within the upper end frame 210. The rotation member 430 may be disposed within the accommodating portion 210a of the upper end frame 210. The rotation member 430 may be rotatably coupled to the support member 420. The rotation member 430 may be configured to surround the support member 420. For example, the rotation body 431 of the rotation member 430 may be configured to surround the coupling portion 422 of the support member 420.

The rotation member 430 may include the rotation body 431. The rotation body 431 may be coupled to the coupling portion 422 of the support member 420. Screw threads or grooves may be formed on an inner surface forming a hole 431a of the rotation body 431 so that the rotation body 431 may be rotatably coupled to the coupling portion 422. The rotation body 431 may protrude in the up-down direction.

The rotation body 431 of the rotation member 430 may be supported by the upper end frame 210. For example, the rotation body 431 may be supported by a frame bottom 211 forming the accommodating portion 210a. Because the rotation body 431 of the rotation member 430 is supported by the frame bottom 211, the rotation member 430 may move the support member 420 in the up-down direction through rotation without moving in the up-down direction.

The upper end frame 210 may be the support frame 210 configured to support the rotation member 430. The frame bottom 211 may be the support frame 210 forming the opening 210b among the upper end frames 210. The frame bottom 211 may be a lower portion of the upper end frame 210.

The rotation member 430 may include a manipulation portion 432. The manipulation portion 432 may protrude from the rotation body 431. For example, the manipulation portion 432 may be formed on a side opposite to the hole 431a of the rotation body 431. The manipulation portion 432 may protrude in a radial direction of the rotation body 431. The manipulation portion 432 may be exposed to the outside of the upper end frame 210 through the opening 210b of the upper end frame 210. The manipulation portion 432 may be accessible through the opening 210b. The opening 210b may be provided as the front opening 210b formed in the front and the rear opening 210b formed in the rear of the upper end frame 210. For example, at least a portion of the manipulation portion 432 may be exposed to the outside through the rear opening 210b.

The user may rotationally move the rotation member 430 by manipulating the manipulation portion 432 exposed through the opening 210b, and accordingly, the support member 420 may move the adjustment part 410 and the display module 100. Therefore, the user may adjust the height of the display module 100 through the rear opening 210b without separating the display module 100 from the front.

In addition, when only the substrate 110 and the first reinforcing frames 121 and 122 provided on an upper side of the display module 100 are separated, the height of the display module 100 may be adjusted through the front opening 210b formed in front of the upper end frame 210. Therefore, the user may move a position of the display module 100 without separating the entire display modules 100.

Therefore, without separating the display 10 disposed on a middle and/or lower side rather than the display 10 disposed on the uppermost side, the height of the display module 100 of the display 10 may be adjusted.

In addition, the height of the display module 100 may be adjusted through the opening 210b even while installing a product thereof.

As a result, the user may easily adjust the height of the display module 100 even while the displays 10 are being stacked and installed or after the installation is completed, and the time and man-hours required for height adjustment may be reduced.

The support member 420 and/or the rotation member 430 may be an adjustment member. For example, the support member 420 may be the first adjustment member. For example, the rotation member 430 may be the second adjustment member.

The display may include a height adjustment device, and the height adjustment device may include the adjustment part, the first adjustment member, and the second adjustment member.

Hereinafter, a position movement mechanism of the display module 100 will be described.

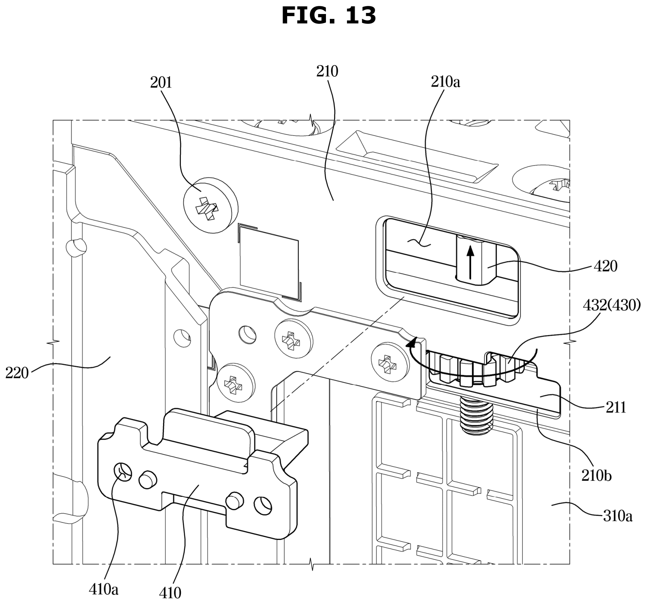

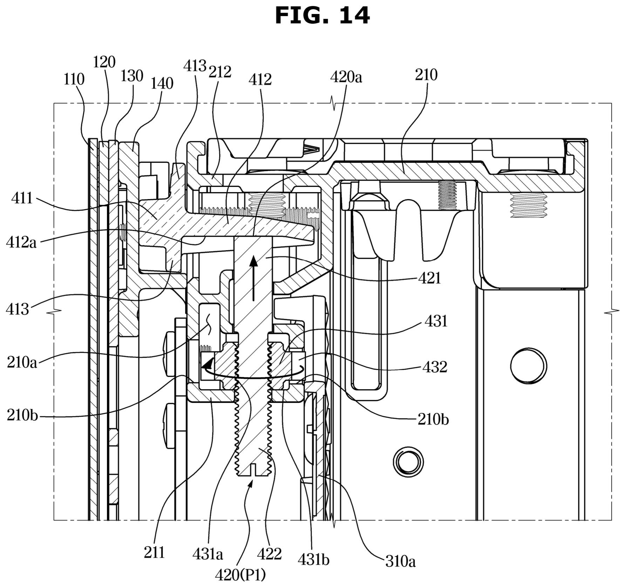

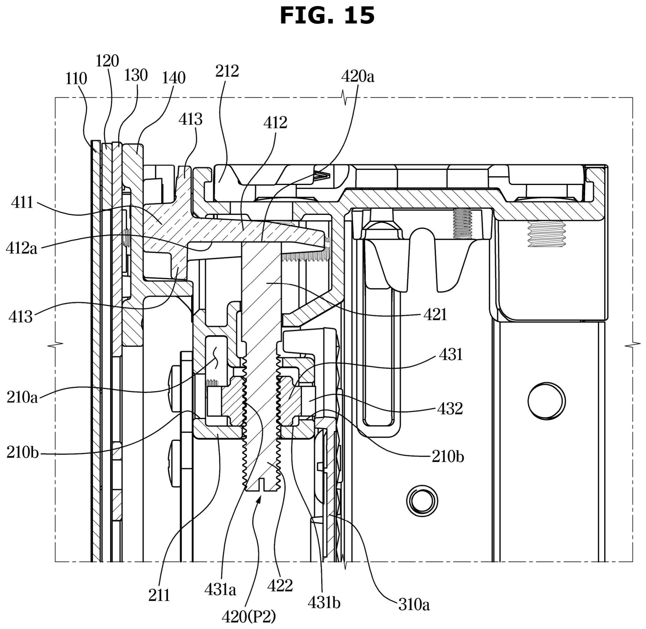

FIG. 13 is a perspective view of the display apparatus according to an embodiment. FIG. 14 is a cross-sectional view of the display apparatus according to an embodiment. FIG. 15 is a cross-sectional view of the display apparatus according to an embodiment.

FIG. 13 is an enlarged perspective view illustrating the support member 420 moved to a second position P2, FIG. 14 is a cross-sectional view illustrating the support member 420 located at a first position P1, and FIG. 15 is a cross-sectional view illustrating the support member 420 located at the second position P2.

Referring to FIGS. 13 to 15, the display may move the support member 420 and the display module 100 in the up-down direction by rotating the rotation member 430. For example, when the rotation member 430 is rotated in a first rotation direction in a state of being supported on the upper end frame 210, the support member 420 may be moved to an upper side. When the support member 420 is moved in an upward direction, the adjustment part 410 supported by the support member 420 may also be moved to the upper side. When the adjustment part 410 is moved to the upper side, the display module 100 coupled to the adjustment part 410 may also be moved to the upper side.

For example, based on the rotation member 430 rotating in the first rotation direction, the support member 420, the adjustment part 410, and the display module 100 may be moved from the first position P1 to the second position P2.

As the adjustment part 410 is moved from the first position P1 to the second position P2 within the upper end frame 210, the support portion 412 of the adjustment part 410 may become close to an upper portion 212 of the upper end frame 210. The support portion 412 of the adjustment part 410 may be in contact with the upper portion 212 of the upper end frame 210.

However, the rotation direction of the rotation member 430 may be different from that illustrated in the drawing.

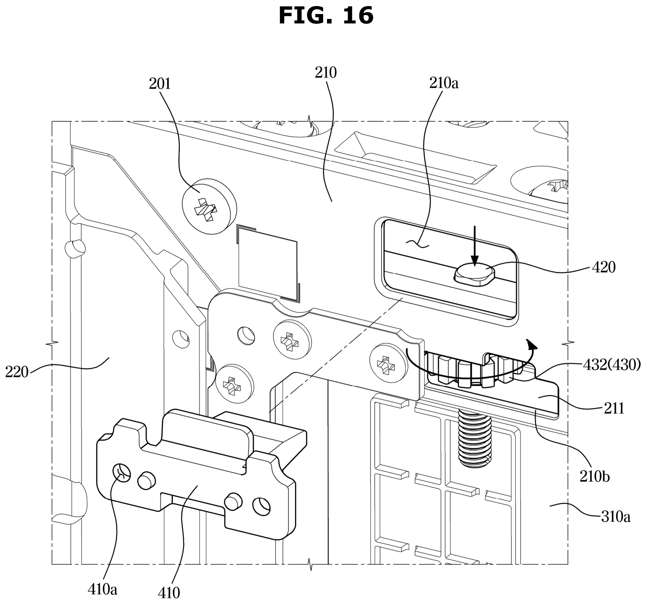

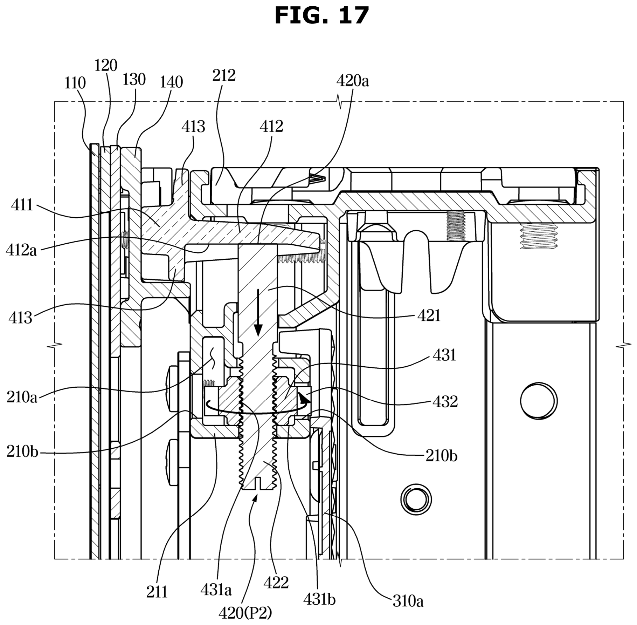

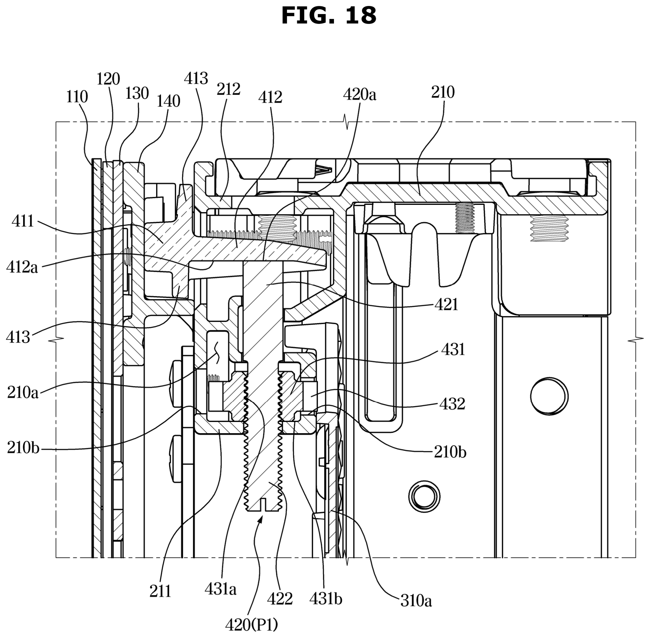

FIG. 16 is a perspective view of the display apparatus according to an embodiment. FIG. 17 is a cross-sectional view of the display apparatus according to an embodiment. FIG. 18 is a cross-sectional view of the display apparatus according to an embodiment.

FIG. 16 is an enlarged perspective view illustrating the support member 420 moved to the first position P1, FIG. 17 is a cross-sectional view illustrating the support member 420 located at the second position P2, and FIG. 18 is a cross-sectional view illustrating the support member 420 located at the first position P1.

Referring to FIGS. 16 to 18, the display 10 may move the support member 420 and the display module 100 in the up-down direction by rotating the rotation member 430. For example, when the rotation member 430 is rotated in a second rotation direction opposite to the first rotation direction in the state of being supported on the upper end frame 210, the support member 420 may be moved to a lower side. When the support member 420 is moved in a downward direction, the adjustment part 410 supported by the support member 420 may also be moved to the lower side. When the adjustment part 410 is moved to the lower side, the display module 100 coupled to the adjustment part 410 may also be moved to the lower side.

For example, based on the rotation member 430 rotating in the second rotation direction, the support member 420, the adjustment part 410, and the display module 100 may be moved from the second position P2 to the first position P1.

As the adjustment part 410 is moved from the second position P2 to the first position P1 within the upper end frame 210, the support portion 412 of the adjustment part 410 may become away from the upper portion 212 of the upper end frame 210.

However, the rotation direction of the rotation member 430 may be different from that illustrated in the drawing.

Because the support member 420 moves only in the up-down direction and the rotation member 430 moves only in the rotation direction, the display module 100 may only move in the up-down direction and may not move in the horizontal direction.

As the LEDs, substrates 110, and electrical components of the plurality of displays 10 generate heat, related components may thermally expand. While the plurality of displays 10 is stacked and operated in the up-down direction, the plurality of display modules 100 provided in the first display 10 may thermally expand and apply a force to the other display modules 100 provided in the adjacent second display 10. This may cause deformation and/or damage to the display 10.

However, the display 10 according to an embodiment may move the support member 420, the adjustment part 410, and the display module 100 by rotating the rotation member 430 through the manipulation portion 432. Therefore, a distance between the display module 100 of the first display 10 and the display module 100 of the adjacent second display 10 may be kept, and the force may be prevented from being applied between the other display modules 100. As a result, the force applied to the other display modules 100 due to thermal expansion is prevented, thereby minimizing deformation of the display module 100.

In addition, because the distance between the plurality of display modules 100 in the plurality of neighboring displays 10 is long, even when a seam is prominent, the plurality of displays 10 may become close by adjusting the height, thereby minimizing the prominence of the seam.

In addition, because the support member 420 supports the display module 100, the display module 100 may be prevented from sagging due to load.

According to an aspect of the present disclosure, a display apparatus capable of easily adjusting a height of a display module by minimizing separation of related components can be provided.

According to an aspect of the present disclosure, a display apparatus capable of preventing damage to a display module due to thermal expansion by easily adjusting a height thereof can be provided.

Effects obtainable from the present disclosure are not limited to the effects mentioned above, and other effects not mentioned will be clearly understood by those skilled in the art from the description below.

A display apparatus according to an embodiment may include a display module 100, a cabinet 200 provided to support the display module, an adjustment part 410 provided in the display module to be movable with respect to the cabinet, a support member 420 movably disposed within the cabinet and configured to support the adjustment part in order to move the adjustment part, a rotation member 430 rotatably coupled to the support member and configured such that the support member, the adjustment part, and the display module are moved based on rotation of the rotation member, and an opening 210b formed in the cabinet to allow the rotation of the rotation member while the display module is mounted on the cabinet.

The rotation member may include a rotation body 431 coupled to the support member, and a manipulation portion 432 protruding from the rotation body to be exposed through the opening.

The manipulation portion may be manipulable through the opening.

The cabinet may include a support frame 210 on which the opening is formed and configured to support a bottom 431b of the rotation member in order to prevent a movement of the rotation member in the up-down direction, and the rotation member may move the support member by rotating while being supported on the support frame.

The display apparatus may further include a cover 300 configured to cover the rear of the display module, wherein the cover may include an adjustment groove 312 recessed from a circumference of the cover to allow manipulation of the rotation member through the opening.

The adjustment part may include an adjustment part body 411 disposed between the display module and the support frame and coupled to the display module, and a support portion 412 extending from the adjustment part body toward the support frame to be supported by the support member.

The support member may include an extension portion 421 inserted into the rotation member and extending in the up-down direction to be in contact with the support portion, and a coupling portion 422 provided on one side of the extension portion and to which the rotation member is rotatably coupled.

The display module may include a substrate 110 on which LEDs are mounted, and a fixing frame 140 disposed at the rear of the substrate and to which the adjustment part body is fixed.

The display module may further include a mounting member 150 disposed between the substrate and the fixing frame to fix the substrate to the fixing frame, and the mounting member may include a mounting groove 151a recessed from a front surface 151 of the mounting member.

The display module may further include reinforcing frames 120 and 130 disposed between the substrate and the fixing frame.

The reinforcing frames may include the first reinforcing frame 120 adhered to the substrate, and the second reinforcing frame 130 coupled to the fixing frame and the first reinforcing frame.

The display apparatus may further include a left frame 240 disposed at a left end of the display module and a right frame 230 disposed at a right end of the display module, wherein the support member may be provided as a plurality of the support members 420, and the plurality of support members may include a left support member adjacent to the left frame and a right support member adjacent to the right frame.

The rotation member may be provided as a plurality of the rotation members, the plurality of rotation members 430 may include a left rotation member rotatably coupled to the left support member and a right rotation member rotatably coupled to the right support member, and the left rotation member and the right rotation member are capable of adjusting a horizontal angle of the display module by being rotated.

The cabinet may be provided as a plurality of the cabinets 200, the plurality of cabinets may include a first cabinet and a second cabinet arranged in a horizontal direction, and the display apparatus may further include a mounting shaft 30 configured to penetrate a side frame of the first cabinet and a side frame of the second cabinet in order to couple the first cabinet and the second cabinet.

The display apparatus may further include a plurality of magnets 20 provided in the cabinet and a plurality of screws 201 provided in the display module, wherein the display module may be coupled to the cabinet by magnetic attraction of the plurality of magnets and the plurality of screws.

A display apparatus according to an embodiment may include a cabinet 200, a display module 100 coupled to the cabinet, and a plurality of height adjustment devices 400 configured to adjust a height of the display module and including a first height adjustment device 400a disposed on the left side of the cabinet and a second height adjustment device 400b disposed on the right side of the cabinet, wherein each of the plurality of height adjustment devices may include a bracket 410 fixed to the display module, a support member 420 configured to support the bracket and be movable in an up-down direction, and a rotation member 430 rotatably coupled to the support member to move the support member in the up-down direction and configured such that the support member, the bracket, and the display module are moved in the up-down direction based on rotation of the rotation member, and an angle of the display module is adjustable based on a movement of each of the support member of the first height adjustment device and the support member of the second height adjustment device.

The cabinet may include side frames 230 and 240 disposed on sides of the display module, a lower end frame 220 disposed at lower ends of the side frames, and an upper end frame 210 disposed at upper ends of the side frames and configured to support a bottom of the rotation member in order to prevent the rotation member from moving in the up-down direction, and the rotation member may move the support member by rotating while being supported on the upper end frame.

The bracket may include a bracket body 411 disposed between the display module and the upper end frame and coupled to the display module, and a support portion 412 extending from the bracket body toward the upper end frame to be supported by the support member.

The support member may include an extension portion 421 inserted into the rotation member and extending in the up-down direction to be in contact with the support portion, and a coupling portion 422 provided below the extension portion and to which the rotation member is rotatably coupled.

A display apparatus according to an embodiment may include a cabinet 200, a display module 100 coupled to the cabinet, a plurality of coupling members 201 provided in the cabinet, a plurality of magnets 20 provided in the display module to couple the display module to the cabinet by magnetic attraction with the plurality of coupling members, a bracket 410 coupled to the display module, a first adjustment member 420 in contact with the bracket to adjust a height of the display module while the display module is coupled to the cabinet, and a second adjustment member 430 configured to rotate to move the first adjustment member in a straight line in order to adjust the height of the display module.

The foregoing has illustrated and described specific embodiments. However, it should be understood by those of skilled in the art that the present disclosure is not limited to the above-described embodiments, and various changes and modifications may be made without departing from the technical idea of the present disclosure described in the following claims.

## Claims

1. A display apparatus comprising:
a display module;
a cabinet to support the display module, the cabinet including an opening;
an adjustment part arrangeable in the display module such that while the adjustment part is arranged in the display module, the adjustment part is movable with respect to the cabinet;
a support member, moveable within the cabinet, and configured to support the adjustment part such that the adjustment part is moveable while supported on the support member;
a rotation member coupleable to the support member and while coupled to the support member, the rotation member is configured to be rotatable such that the support member, the adjustment part, and the display module are moved based on a rotation of the rotation member; and
wherein the rotation member is accessible through the opening of the cabinet to allow the rotation of the rotation member while the display module is supported on the cabinet.

2. The display apparatus according to claim 1, wherein
the rotation member comprises:
a rotation body coupled to the support member; and
a manipulation portion protruding from the rotation body to be exposed through the opening.

3. The display apparatus according to claim 2, wherein
the manipulation portion is manipulable through the opening.

4. The display apparatus according to claim 3, wherein
the cabinet comprises:
a support frame on which the opening is formed and configured to support a bottom of the rotation member in order to prevent a movement of the rotation member along an up-down direction, and
the rotation member moves the support member by rotating while being supported on the support frame.

5. The display apparatus according to claim 4, further comprising
a cover configured to cover a rear of the display module,
wherein the cover comprises an adjustment groove recessed from a circumference of the cover to allow manipulation of the rotation member through the opening.

6. The display apparatus according to claim 2, wherein
the adjustment part comprises:
an adjustment part body, between the display module and the support member, and coupled to the display module; and
a support portion extending from the adjustment part body toward the support member to be supported by the support member.

7. The display apparatus according to claim 6, wherein
the support member comprises:
an extension portion, insertable into the rotation member, and extending along an up-down direction to be in contact with the support portion; and
a coupling portion on one side of the extension portion and to which the rotation member is rotatably coupled.

8. The display apparatus according to claim 6, wherein
the display module comprises:
a substrate on which LEDs are mounted; and
a fixing frame, at a rear of the substrate, and to which the adjustment part body is fixed.

9. The display apparatus according to claim 8, wherein
the display module further comprises
a mounting member between the substrate and the fixing frame to fix the substrate to the fixing frame, and
the mounting member comprises a mounting groove recessed from a front surface of the mounting member.

10. The display apparatus according to claim 9, wherein
the display module further comprises
a reinforcing frame between the substrate and the fixing frame.

11. The display apparatus according to claim 10, wherein the reinforcing frame is a first reinforcing frame adhered to the substrate and display module further comprises:
a second reinforcing frame coupleable to the fixing frame and the first reinforcing frame.

12. The display apparatus according to claim 3, further comprising:
a left frame at a left end of the display module; and
a right frame at a right end of the display module,
wherein the support member is among a plurality of support members, and
the plurality of support members comprises:
a left support member adjacent to the left frame; and
a right support member adjacent to the right frame.

13. The display apparatus according to claim 12, wherein
the rotation member is among a plurality of rotation members,
the plurality of rotation members comprises:
a left rotation member rotatably coupleable to the left support member; and
a right rotation member rotatably coupleable to the right support member, and
the left rotation member and the right rotation member allow a horizontal angle of the display module to be adjusted by being rotated.

14. The display apparatus according to claim 13, wherein
the cabinet is among a plurality of cabinets,
the plurality of cabinets comprise a first cabinet and a second cabinet arranged along a horizontal direction, and
the display apparatus further comprises
a mounting shaft configured to penetrate a side frame of the first cabinet and a side frame of the second cabinet in order to couple the first cabinet and the second cabinet.

15. The display apparatus according to claim 1, further comprising:
a plurality of magnets in the cabinet; and
a plurality of screws in the display module,
wherein the display module is coupled to the cabinet by magnetic attraction between the plurality of magnets and the plurality of screws.
